# EUROPEAN PATENT SPECIFICATION

(11) **EP 3 139 388 B1**
(45) Date of publication and mention of the grant of the patent: **02.10.2019**
(21) Application number: 15835403.5
(22) Date of filing: 03.08.2015
(51) Int. Cl.: H01B 1/22, H05K 3/10

(54) **COMPOSITION FOR CONDUCTIVE PATTERN FORMATION, CONDUCTIVE PATTERN FORMATION METHOD USING SAME, AND RESIN STRUCTURE HAVING CONDUCTIVE PATTERN**
ZUSAMMENSETZUNG ZUR BILDUNG EINER LEITFÄHIGEN STRUKTUR, VERFAHREN ZUR BILDUNG EINER LEITFÄHIGEN STRUKTUR DAMIT UND HARZSTRUKTUR MIT LEITFÄHIGER STRUKTUR
COMPOSITION POUR FORMATION DE MOTIF CONDUCTEUR, PROCÉDÉ DE FORMATION DE MOTIF CONDUCTEUR L'UTILISANT ET STRUCTURE DE RÉSINE AYANT UN MOTIF CONDUCTEUR

(30) Priority: 29.08.2014 KR 20140114387
(43) Date of publication of application: 08.03.2017
(73) Proprietor: LG Chem, Ltd., Seoul 150-721 (KR)
(72) Inventor: PARK, Chee-Sung, Daejeon 34122 (KR); KIM, Jae Hyun, Daejeon 34122 (KR); JUN, Shin Hee, Daejeon 34122 (KR); SHIN, Bu Gon, Daejeon 34122 (KR); KIM, Jae Jin, Daejeon 34122 (KR); PARK, Cheol-Hee, Daejeon 34122 (KR); JEONG, Han Nah, Daejeon 34122 (KR); SEONG, Eun Kyu, Daejeon 34122 (KR); LEE, Su Jeong, Daejeon 34122 (KR); LEE, Ha Na, Daejeon 34122 (KR)
(74) Representative: Goddar, Heinz J.
(86) International application number: PCT/KR2015/008100
(87) International publication number: WO 2016/032142

(56) References cited:
- JP-A- H07 331 125
- KR-A- 20040 021 614
- KR-A- 20120 121 219
- KR-A- 20120 124 167
- KR-A- 20130 064 824
- US-A1- 2004 241 422
- US-A1- 2014 127 321

## Description

### [CROSS REFERENCE TO RELATED APPLICATIONS]

This application claims the benefit of Korean Patent Application No. 10-2014-0114387 on August 29, 2014 with the Korean Intellectual Property Office.

### [TECHNICAL FIELD]

The present invention relates to a composition for forming a conductive pattern, which has excellent thermal and mechanical properties and enables formation of a fine conductive pattern onto a variety of polymer resin products or resin layers by a very simplified process, a method of forming the conductive pattern using the same, and a resin structure having the conductive pattern.

### [BACKGROUND OF ART]

With the recent development of microelectronic technology, a need for structures having a fine conductive pattern which is formed on the surface of a polymer resin substrate (or product) such as a variety of resin products or resin layers has grown. The conductive pattern on the surface of the polymer resin substrate and the structures may be applied to form various objects such as antenna integrated into a mobile phone case, a variety of sensors, MEMS structures, RFID tags, etc.

As described above, with increasing interest in the technology of forming the conductive pattern on the surface of the polymer resin substrate, several technologies regarding this were suggested. However, a method capable of more effectively using these technologies has not been suggested yet.

For example, according to the previously known technology, a method of forming the conductive pattern by forming a metal layer on the surface of the polymer resin substrate and then applying photolithography, a method of forming the conductive pattern by printing a conductive paste or the like may be considered. However, when the conductive pattern is formed according to this technology, there are disadvantages that a process or equipment to be needed becomes too complicated, or it is difficult to form an excellent fine conductive pattern.

Accordingly, there is a continuous need to develop a technology capable of more effectively forming the fine conductive pattern on the surface of the polymer resin substrate by a simplified process.

US 2004/241422 A1 discloses a conductor track structure and a method for producing the same.

### [DETAILED DESCRIPTION OF THE INVENTION]

### [Technical Problem]

The above problems of the prior art are solved in accordance with the subject-matter of the independent claims. Preferred embodiments result from the subclaims.

The present invention provides a composition for forming a conductive pattern, which has excellent thermal and mechanical properties and enables formation of a fine conductive pattern onto a variety of polymer resin products or resin layers by a very simplified process, and a method of forming the conductive pattern using the same.

Further, the present invention provides a resin structure having a conductive pattern, which is formed from the composition for forming the conductive pattern, etc.

### [Technical Solution]

The present invention provides a composition for forming a conductive pattern, the composition comprising a polymer resin; and
a non-conductive metal compound comprising a coinage metal element [Group 11 (Group IB)] and a non-metal element, the non-conductive metal compound having a three-dimensional structure formed by vertex sharing of tetrahedrons comprising the Group 11 metal element, wherein the non-conductive metal compound is suitable to form a metal core comprising the Group 11 metal element or an ion thereof by electromagnetic irradiation,
wherein the non-conductive metal compound comprises a compound selected from the group consisting of CuI, CuCl, CuBr, CuF, and AgI,
the composition further comprising one or more additives selected from the group consisting of a heat stabilizer, a UV stabilizer, a flame retardant, a lubricant, an antioxidant, an inorganic filler, a color additive, an impact modifier, and a functional modifier,
wherein the color additive comprises one or more selected from the group consisting of carbon black, graphite, graphene, clay, talc, TiO₂, ZrO₂, Fe₂O₃, BaSO₄, CaCO₃, SiO₂, ZnS, ZnO, ZnCrO₄, Cr₂O₃, CoO·nAl₂O₃, Co₃(PO₄)₂, copper phthalocyanine, and quinacridone.

The non-conductive metal compound may include a zinc blende selected from CuI, CuCl, CuBr, or CuF, and a wurtzite compound, namely AgI. These non-conductive metal compounds form a metal core well by electromagnetic irradiation, thereby forming a more excellent conductive pattern.

Further, the non-conductive metal compound may have an average particle size of 1 µm or less, or an average particle size of 100 nm to 1 µm.

Meanwhile, when the above-described composition for forming the conductive pattern is irradiated with a laser electromagnetic wave having a wavelength of approximately 200 nm to 11000 nm at an average power of approximately 1 to 20 W, the metal core is formed. By controlling the conditions of laser electromagnetic irradiation, the metal core may be more effectively formed on the polymer resin of the composition, and therefore, a more excellent conductive pattern may be formed.

With regard to the above-described composition for forming the conductive pattern, the polymer resin may include a thermosetting resin or a thermoplastic resin, and more specific examples thereof may include an acrylonitrile butadiene styrene (ABS) resin, a polyalkyleneterephthalate resin, a polycarbonate resin, a polypropylene resin, polyphthalamide, nylon, an elastomer resin, etc., and the polyalkyleneterephthalate resin may include, for example, a polybutyleneterephthalate resin, a polyethyleneterephthalate resin, etc.

Further, with regard to the composition for forming the conductive pattern, the non-conductive metal compound may be included in an amount of approximately 1 to 10% by weight, based on the total composition, and the polymer resin may be included in the remaining amount.

The composition for forming the conductive pattern further includes one or more additives selected from the group consisting of a heat stabilizer, a UV stabilizer, a flame retardant, a lubricant, an antioxidant, an inorganic filler, a color additive, an impact modifier, and a functional modifier, in addition to the above-described polymer resin and the predetermined non-conductive metal compound.

The color additive is a substance which is added in order to impart a color to the above-described composition for forming the conductive pattern, and inorganic pigments selected from carbon black, graphite, graphene, clay, talc, TiO₂, ZrO₂, Fe₂O₃, BaSO₄, CaCO₃, SiO₂, ZnS, ZnO, ZnCrO₄, Cr₂O₃, CoO·nAl₂O₃, and Co₃(PO₄)₂, or organic pigments selected from copper phthalocyanine, and quinacridone, are added.

Meanwhile, the present invention also provides a method of forming a conductive pattern on a polymer resin substrate such as a resin product or a resin layer by direct electromagnetic irradiation using the above-described composition for forming the conductive pattern. The method of forming the conductive pattern includes molding the above-described composition for forming the conductive pattern to a resin product or applying it to another product to form a resin layer; irradiating an electromagnetic wave to a predetermined region of the resin product or the resin layer to generate a metal core including the Group 11 metal element or the ion thereof from the non-conductive metal compound; and chemically reducing or plating the region generating the metal core in a plating solution containing metal ions to form the conductive metal layer.

In the generating of the metal core of the above method of forming the conductive pattern, a laser electromagnetic wave having various wavelengths from approximately 200 nm to approximately 11,000 nm may be irradiated at an average power of approximately 1 W to approximately 20 W, and as a result, the metal core may be more effectively formed and a more excellent conductive pattern may be formed.

Further, when the generating of the metal core by electromagnetic irradiation is carried out, the non-conductive metal compound is partially exposed on the surface of the predetermined region of the resin product or the resin layer, and the metal core is generated therefrom, thereby forming a surface (hereinafter, "adhesion-activated surface") which is activated to have higher adhesion. Subsequently, conductive metal ions are chemically reduced by chemical reduction of the Group 11 metal ion included in the metal core or by electroless plating thereof, and thus the conductive metal layer may be formed on the adhesion-activated surface. At the time of the electroless plating, the metal cores may function as a kind of seed to form a strong bond with the conductive metal ions in a plating solution when the conductive metal ions are chemically reduced. As a result, the conductive metal layer may be selectively formed in an easier manner.

Further, in the reducing or plating, the predetermined region of the resin product or resin layer on which the metal core is generated may be treated with an acidic or basic solution including a reducing agent, and this solution may include one or more selected from the group consisting of formaldehyde, hypophosphite, dimethylamino borane (DMAB), diethylamino borane (DEAB), and hydrazine as the reducing agent. In another embodiment, in the reducing, the predetermined region may be treated with an electroless plating solution including a reducing agent and a conductive metal ion.

Meanwhile, the present invention also provides a resin structure comprising:
a polymer resin substrate;
a non-conductive metal compound that comprises a Group 11 metal element and a non-metal element and is dispersed in a polymer resin substrate, the non-conductive metal compound having a three-dimensional structure formed by vertex sharing of tetrahedrons comprising the Group 11 metal element;
an adhesion-activated surface obtainable by generating a metal core comprising the Group 11 metal or the ion thereof by exposing the non-conductive metal compound on the surface of a predetermined region of the polymer resin substrate; and
a conductive metal layer formed on the adhesion-activated surface,
wherein the non-conductive metal compound comprises a compound selected from the group consisting of CuI, CuCl, CuBr, CuF, and AgI.

In the resin structure, the predetermined region where the adhesion-activated surface and the conductive metal layer are formed may correspond to the region of the polymer resin substrate to which an electromagnetic wave is irradiated.

### [ADVANTAGEOUS EFFECTS]

According to the present invention, provided are a composition for forming a conductive pattern, which has excellent thermal and mechanical properties and enables more effective formation of a fine conductive pattern on a polymer resin substrate such as a variety of polymer resin products or resin layers by a very simplified process of laser electromagnetic irradiation, a method of forming the conductive pattern using the same, and a resin structure having the conductive pattern.

Since the composition for forming the conductive pattern or the method of forming the conductive pattern is used to easily achieve a white color or other different color and has superior thermal and mechanical stability, it may be very effectively applied to conductive patterns for antenna on a variety of resin products, such as a mobile phone case, RFID tags, various sensors, MEMS structures or the like.

### [BRIEF DESCRIPTION OF DRAWINGS]

FIG. 1 illustrates an exemplary three-dimensional structure of a non-conductive metal compound which is included in a composition for forming a conductive pattern according to one embodiment of the present invention;
FIG. 2 illustrates another exemplary three-dimensional structure of the non-conductive metal compound which is included in the composition for forming the conductive pattern according to one embodiment of the present invention;
FIGS. 3 to 5 illustrate a schematic diagram showing each step of an exemplary method of forming a conductive pattern according to another embodiment of the present invention;
FIGS. 6 and 7 show an electron microscopic image and X-ray diffraction pattern of CuI power which is prepared and then pulverized in Preparation Example 1;
FIG. 8 shows the result of X-ray diffraction analysis of a resin substrate, after obtaining the resin substrate including CuI powder in Example 1;
FIG. 9 shows the result of an electron microscopic image to examine changes of the surface conditions of the resin substrate including CuI powder after laser irradiation of the resin substrate in Example 1;
FIG. 10 shows the result of X-ray diffraction analysis of a resin substrate, after obtaining the resin substrate including CuI powder and a color additive (TiO₂) in Example 4;
FIG. 11 shows the result of an electron microscopic image to examine changes of the surface conditions of the resin substrate including CuI powder and the color additive (TiO₂) after laser irradiation of the resin substrate in Example 4;
FIG. 12 shows images of a polycarbonate resin substrate and resin substrates prepared in Examples 2 and 4; and
FIG. 13 shows a conductive pattern (left) formed immediately after plating and a conductive pattern (right) after an adhesion performance test (cross-cut test according to the standard ISO 2409) in Example 2.

### [DETAILED DESCRIPTION OF THE EMBODIMENTS]

Hereinafter, a composition for forming a conductive pattern, a method of forming the conductive pattern using the same, and a resin structure having the conductive pattern according to specific embodiments of the present invention will be described.

According to one embodiment of the present invention, provided is a composition for forming a conductive pattern, the composition comprising a polymer resin; and
a non-conductive metal compound comprising a coinage metal element [Group 11 (Group IB)] and a non-metal element, the non-conductive metal compound having a three-dimensional structure formed by vertex sharing of tetrahedrons comprising the Group 11 metal element, wherein the non-conductive metal compound is suitable to form a metal core comprising the Group 11 metal element or an ion thereof by electromagnetic irradiation,
wherein the non-conductive metal compound comprises a compound selected from the group consisting of CuI, CuCl, CuBr, CuF, and AgI,
the composition further comprising one or more additives selected from the group consisting of a heat stabilizer, a UV stabilizer, a flame retardant, a lubricant, an antioxidant, an inorganic filler, a color additive, an impact modifier, and a functional modifier,
wherein the color additive comprises one or more selected from the group consisting of carbon black, graphite, graphene, clay, talc, TiO₂, ZrO₂, Fe₂O₃, BaSO₄, CaCO₃, SiO₂, ZnS, ZnO, ZnCrO₄, Cr₂O₃, CoO·nAl₂O₃, Co₃(PO₄)₂, copper phthalocyanine, and quinacridone.

After molding a polymer resin product or a resin layer using the composition for forming the conductive pattern according to one embodiment of the present invention, metal cores including the Group 11 metal element or the ion thereof may be formed from the non-conductive metal compound by laser electromagnetic irradiation. These metal cores are selectively exposed on a predetermined region to which an electromagnetic wave is irradiated, and thus an adhesion-activated surface may be formed on the surface of the polymer resin substrate. Subsequently, by chemical reduction of the metal core including the Group 11 metal element or the ion thereof or by electroless plating using the metal cores as a seed and a plating solution containing the conductive metal ions, a conductive metal layer may be formed on the adhesion-activated surface including the metal cores. Through this process, the conductive metal layer, namely, fine conductive pattern may be selectively formed only on the predetermined region of the polymer resin substrate, to which the electromagnetic wave is irradiated.

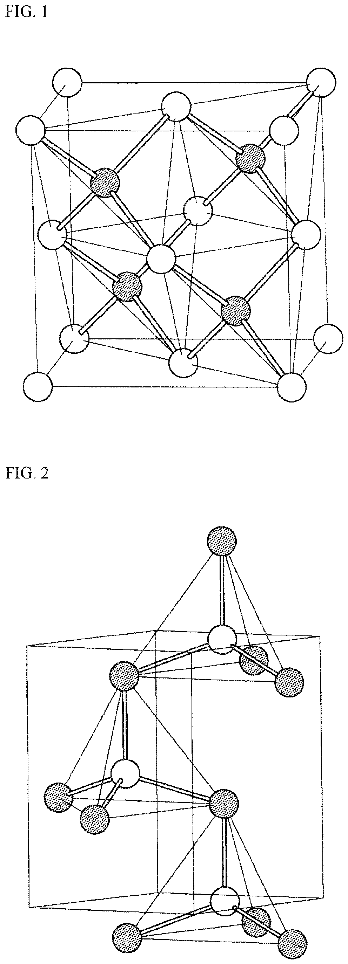

In particular, one of factors causing formation of the metal cores and the adhesion-activated surface and formation of the superior conductive pattern by electromagnetic irradiation may be the specific three-dimensional structure of non-conductive metal compound included in the composition of one embodiment. An exemplary three-dimensional structure of the non-conductive metal compound included in the composition for forming the conductive pattern according to one embodiment of the present invention is illustrated in FIGS. 1 and 2.

Referring to FIGS. 1 and 2, the three-dimensional structure of the non-conductive metal compound is a three-dimensional structure formed by vertex sharing of tetrahedrons including the Group 11 metal element, in which the Group 11 metal element or the non-metal element may be included as vertices. Further, the tetrahedrons of the three-dimensional structure of the non-conductive metal compound include an element different from the elements constituting the vertex, for example, the element other than one of the Group 11 metal element and the non-metal element which is included as the vertex of the tetrahedron, and these vertices of the tetrahedrons are connected to each other, thereby forming the three-dimensional structure.

Before electromagnetic irradiation, the non-conductive metal compound having the particular three-dimensional structure exhibits non-conductivity and has excellent compatibility with the polymer resin, and also is chemically stable in the solution used in reduction or plating treatment to maintain non-conductivity. Therefore, the non-conductive metal compound is uniformly dispersed in the polymer resin substrate and maintains chemically stable state to exhibit non-conductivity in the region to which electromagnetic wave is not irradiated.

In contrast, the Group 11 metal or ion thereof may be readily generated from the non-conductive metal compound in the predetermined region to which an electromagnetic wave such as laser is irradiated. In this regard, it is expected that readily generation of the metal or ion thereof from the non-conductive metal compound is attributed to the above-described three-dimensional structure resulting from the tetrahedron of the non-conductive metal compound. Since the non-conductive metal compound having the tetrahedral structure has Chemical Formula of AX, in which the three-dimensional structure is formed by vertex sharing of tetrahedrons of AX, the Group 11 metal or the ion thereof may be more readily released. As such, the metal or the ion thereof is more readily released from the non-conductive metal compound by electromagnetic irradiation, which is one of factors causing formation of the metal cores and the adhesion-activated surface.

Meanwhile, the non-conductive metal compound may be represented by the following Chemical Formula 1:

[Chemical Formula 1] AX

wherein A is a coinage metal element [Group 11 (Group IB)], and X is halogen [Group 17 (Group VIIA)].

More specifically, the coinage metal element may be exemplified by copper (Cu), silver (Ag), gold (Au), roentgenium (Rg), etc., and the halogen may be exemplified by fluorine (F), chlorine (Cl), bromine (Br), iodine (I), etc.

In particular, the non-conductive compound having Chemical Formula 1 of AX has a structure, in which outermost orbitals of A and X are filled with electrons, respectively. Therefore, electron and orbital transitions may be minimized, and thus, the non-conductive compound shows a light color and it is possible to achieve a white color even by using a small amount of the color additive. Accordingly, resin products or resin layers having many different colors may be manufactured.

However, the experimental results of the present inventors revealed that formation of the metal cores and the adhesion-activated surface is not attributed only to the particular three-dimensional structure of the non-conductive metal compound. The present inventors continued to conduct experiments and to study, and they found that among the nonconductive metal compounds of the above particular three-dimensional structure, for example, a particular compound of CuI, CuCl, CuBr, CuF, AgI, is selected and included, and as a result, the compound of one embodiment is able to show higher absorption and sensitivity with respect to electromagnetic wave such as a laser with a particular wavelength. In addition, when the after-mentioned conditions of the electromagnetic irradiation such as laser, etc. are controlled, the metal core and adhesion-activated surface may be finally formed, and a superior fine conductive pattern may be formed by electromagnetic irradiation such as laser and subsequent reduction or plating treatment.

Due to the above unique three-dimensional structure of the non-conductive metal compound and the properties thereof, and control of the above described conditions for metal core formation, the composition for forming the conductive pattern of one embodiment is able to readily form a superior fine conductive pattern, compared to other composition including a compound having other three-dimensional structure for white color achievement or other composition without metal core formation. Furthermore, owing to these features, the composition for forming the conductive pattern of one embodiment is able to more readily form a fine conductive metal layer having thermal stability and mechanical stability, compared to other composition including a non-conductive metal compound of Cu₂(OH)PO₄, Sb-SnO₂, etc., even though the amount of the non-conductive metal compound, more specifically, the amount or content of the Group 11 metal is reduced.

Additionally, since a compound having a different three-dimensional structure such as spinel, represented by CuCr₂O₄, etc. has a dark black color, a composition including this non-conductive metal compound is not suitable for production of the polymer resin product or the resin layer having different colors. In contrast, the above non-conductive metal compound included in the composition for forming the conductive pattern of one embodiment, for example, CuI, AgI, etc. shows a light color, and therefore, even though a small amount of the additive is used, it is possible to achieve a white color, thereby producing resin products or resin layers having different colors. Further, the non-conductive metal compound of one embodiment may exhibit improved thermal stability, mechanical stability, and environment-friendly property, compared to a known non-conductive metal compound of Cu₂(OH)PO₄, Sb-SnO₂, etc., which has been used to produce resin products or resin layers with many different colors. Therefore, the composition for forming the conductive pattern of one embodiment may be suitably used for the production of resin products or resin layers having the conductive pattern and many different colors.

As such, when the composition for forming the conductive pattern according to one embodiment of the present invention is used, a superior fine conductive pattern may be easily formed on the polymer resin substrate by a very simple process of laser electromagnetic irradiation and reduction or plating treatment of the corresponding region. Moreover, owing to the unique three-dimensional structure or the metal core formation of the non-conductive metal compound, the conductive pattern may be more effectively and easily formed, and resin products or resin layers having many different colors, in particular, a white color may be properly produced to meet consumers' demand. Therefore, the composition for forming the conductive pattern is applied to very effectively form a conductive pattern for antenna on a variety of polymer resin products or resin layers, RFID tags, various sensors, MEMS structures, etc.

The non-conductive metal compound may have an average particle size of approximately 1 µm or less, or approximately 100 nm to approximately 1 µm. If the average particle size of the non-conductive metal compound is too large, a fine conductive pattern may not be uniformly formed.

In addition, even though the non-conductive metal compound having the three-dimensional structure of the above-described tetrahedral shape is used, but conditions of electromagnetic irradiation such as laser are not controlled within the appropriate range, metal cores may not be formed, and in this case, a fine conductive pattern having excellent adhesion strength to the polymer resin may not be formed.

Specifically, when the above-described composition for forming the conductive pattern of one embodiment is irradiated with a wavelength of various regions between 200 nm to 11000 nm, for example, a laser electromagnetic wave having a wavelength of approximately 248 nm, approximately 308 nm, approximately 355 nm, approximately 532 nm, approximately 585 nm, approximately 755 nm, approximately 1064 nm, approximately 1550 nm, approximately 2940 nm or approximately 10600 nm at an average power of approximately 1 W to approximately 20 W, or approximately 3 W to approximately 15 W, metal cores may be formed in the region, to which the electromagnetic wave is irradiated. Preferably, the laser electromagnetic wave may have a wavelength corresponding to the infrared region of approximately 1000 nm to approximately 1200 nm, or approximately 1060 nm to approximately 1070 nm, or approximately 1064 nm. As the conditions of electromagnetic irradiation such as laser, etc. are controlled within the range, metal cores may be more effectively formed in the laser-irradiated region of the composition of one embodiment, resulting in formation of the superior conductive pattern. However, the conditions of electromagnetic irradiation for metal core formation may vary depending on the specific type or the composition of the non-conductive metal compound and the polymer resin which are practically used.

Further, in the composition for forming the conductive pattern of one embodiment, any thermosetting resin or thermoplastic resin capable of forming various polymer resin products or resin layers may be used as the polymer resin without limitation. In particular, the non-conductive metal compound having the particular three-dimensional structure described above exhibits excellent compatibility and uniform dispersibility with respect to various polymer resins, and the composition of one embodiment includes various polymer resins to be molded to various resin products or resin layers. Specific examples of the polymer resin may include an acrylonitrile butadiene styrene (ABS) resin, a polyalkyleneterephthalate resin, a polycarbonate resin, a polypropylene resin, a polyphthalamide resin, nylon, an elastomer, etc., and the polyalkyleneterephthalate resin may include, for example, a polybutyleneterephthalate resin, a polyethyleneterephthalate resin, etc.

Further, in the composition for forming the conductive pattern, the non-conductive metal compound may be included in an amount of approximately 1% by weight to approximately 10% by weight, or approximately 1.5% by weight to approximately 7% by weight, based on the total composition, and the polymer resin may be included in the remaining amount. When the content is within the above range, the polymer resin product or the resin layer formed from the composition properly maintains the basic physical properties such as thermal and mechanical properties, and the conductive pattern is also preferably formed on a predetermined region by electromagnetic irradiation. Further, formation of the metal cores and the superior conductive pattern may be more preferably ensured by the composition ratio.

Additionally, the composition of one embodiment includes the non-conductive metal compound having the particular three-dimensional structure to form metal cores or the like, thereby more effectively forming the conductive pattern by electromagnetic irradiation even though the composition includes a lower amount of non-conductive metal compound. Therefore, owing to the lower content of the non-conductive metal compound, it is easier to maintain excellent basic physical properties of the resin product or the resin layer.

The composition for forming the conductive pattern may further include one or more additives selected from the group consisting of a heat stabilizer, a UV stabilizer, a flame retardant, a lubricant, an antioxidant, an inorganic filler, a color additive, an impact modifier, and a functional modifier, in addition to the above-described polymer resin and the predetermined non-conductive metal compound. Various other additives known to be used in the composition for molding the resin product may be also used without limitation.

The color additive is a substance which is added in order to impart a color to the above-described composition for forming the conductive pattern, and if necessary, inorganic pigments such as carbon black, graphite, graphene, clay, talc, TiO₂, ZrO₂, Fe₂O₃, BaSO₄, CaCO₃, SiO₂, ZnS, ZnO, ZnCrO₄, Cr₂O₃, CoO·nAl₂O₃, Co₃(PO₄)₂, etc., or organic pigments such as copper phthalocyanine, quinacridone, etc. may be added alone or in a mixture.

Meanwhile, according to another embodiment of the present invention, provided is a method of forming the conductive pattern on the polymer resin substrate such as the resin product or the resin layer by direct electromagnetic irradiation using the above-described composition for forming the conductive pattern. The method of forming the conductive pattern may include molding the above-described composition for forming the conductive pattern to a resin product or applying it to another product to form a resin layer; irradiating an electromagnetic wave to a predetermined region of the resin product or the resin layer to generate a metal core including the Group 11 metal element or the ion thereof from the non-conductive metal compound; and chemically reducing or plating the region generating the metal core to form the conductive metal layer.

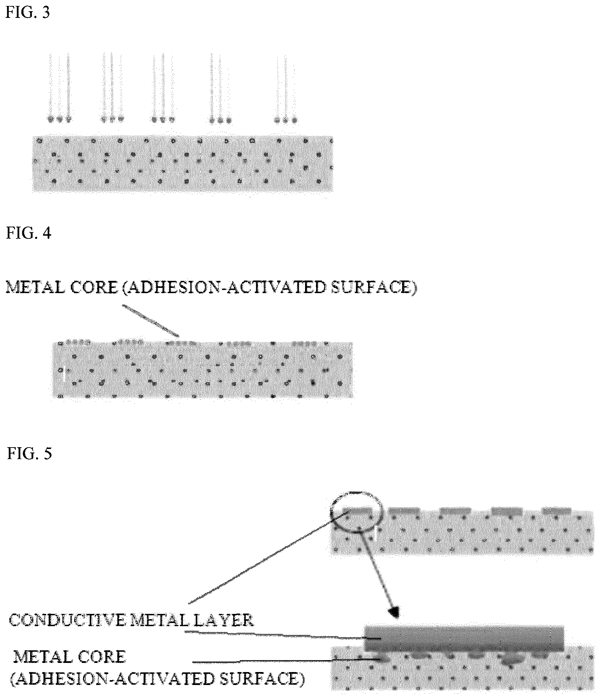

Hereinafter, each step of the method of forming the conductive pattern according to another embodiment will be described with reference to the accompanying drawings. For reference, FIGS. 3 to 5 illustrate a schematic diagram showing each step of an exemplary method of forming the conductive pattern.

In the method of forming the conductive pattern, first, the above-described composition for forming the conductive pattern is molded to the resin product or applied to another product to form the resin layer. In the molding of the resin product or the forming of the resin layer, a method of molding a product or a method of forming a resin layer using a general polymer resin composition may be applied without limitation. For example, when the resin product is molded using the composition, the composition for forming the conductive pattern is extruded and cooled to form pellets or particles, which are subjected to injection molding in a desired shape, thereby manufacturing a variety of polymer resin products.

The polymer resin product or the resin layer thus formed may have the above described non-conductive metal compound of the particular three-dimensional structure which is uniformly dispersed on the resin substrate formed from the polymer resin. In particular, since the non-conductive metal compound has excellent compatibility, sufficient solubility, and chemical stability for various polymer resins, the non-conductive metal compound is uniformly dispersed throughout the resin substrate and maintains non-conductivity.

After forming the polymer resin product or the resin layer, as illustrated in FIG. 3, an electromagnetic wave such as laser, etc. may be irradiated to a predetermined region of the resin product or the resin layer, on which the conductive pattern is intended to be formed. When the electromagnetic wave is irradiated, the Group 11 metal or the ion thereof may be released from the non-conductive metal compound, and metal cores including the same may be generated.

More specifically, when the generating of the metal cores by electromagnetic irradiation is carried out, a part of the non-conductive metal compound is exposed on the surface of the predetermined region of the resin product or the resin layer, and metal cores are generated therefrom, and thus the adhesion-activated surface which is activated to have higher adhesion may be formed. Since the adhesion-activated surface is selectively formed on the specific region to which the electromagnetic wave is irradiated, the conductive metal layer may be selectively formed on the predetermined region of the polymer resin substrate more favorably, when conductive metal ions are chemically reduced by chemical reduction of the Group 11 metal ions included in the metal core and the adhesion-activated surface, or electroless plating thereof in the reduction or plating step described below. More specifically, upon electroless plating, the metal cores function as a kind of seed to form a strong bond with the conductive metal ions included in the plating solution, when the conductive metal ions are chemically reduced. As a result, a superior conductive metal layer may be selectively formed in an easier manner.

Meanwhile, in the generating of the metal cores, a laser electromagnetic wave among electromagnetic waves may be irradiated, for example, a laser electromagnetic wave having a variety of wavelengths between 200 nm to 11000 nm, for example, a laser electromagnetic wave having a wavelength of approximately 248 nm, approximately 308 nm, approximately 355 nm, approximately 532 nm, approximately 585 nm, approximately 755 nm, approximately 1064 nm, approximately 1550 nm, approximately 2940 nm or approximately 10600 nm may be irradiated at an average power of approximately 1 W to approximately 20 W, or approximately 3 W to approximately 15 W.

By the laser electromagnetic irradiation, formation of the metal cores from the non-conductive metal compound may be more preferably ensured, and the adhesion-activated surface including the same may be selectively formed on the predetermined region and exposed.

Meanwhile, after the generating of the metal cores, the forming of the conductive metal layer by chemically reducing or plating the region generating metal cores may be carried out. As a result of the reducing or plating, the conductive metal layer may be selectively formed on the predetermined region exposing the metal core and the adhesion-activated surface, and on the other region, the chemically stable non-conductive metal compound maintains its non-conductivity. Therefore, the fine conductive pattern may be selectively formed only on the predetermined region of the polymer resin substrate.

In the reducing or plating, the predetermined region of the resin product or the resin layer which generates metal cores may be treated with an acidic or basic solution containing a reducing agent, and this solution may contain one or more selected from the group consisting of formaldehyde, hypophosphite, dimethylamino borane (DMAB), diethylaminoborane (DEAB) and hydrazine as the reducing agent. In another embodiment, the region may be treated with an electroless plating solution containing the reducing agent and conductive metal ions in the reducing.

As the reducing or plating is carried out, the Group 11 metal ions included in the metal core are reduced, or the conductive metal ions in the plating solution are chemically reduced in the region where the metal cores are formed as a seed, and therefore, an excellent conductive pattern may be selectively formed on the predetermined region. In this regard, the metal core and the adhesion-activated surface may form a strong bond with chemically reduced conductive metal ions, and as a result, the conductive pattern may be more easily formed selectively on the predetermined region.

Meanwhile, according to still another embodiment, provided is a resin structure having the conductive pattern which is obtained by using the composition for forming the conductive pattern and the method of forming the conductive pattern described above. The resin structure may include the polymer resin substrate; the non-conductive metal compound that includes the Group 11 metal element and the non-metal element and is dispersed in the polymer resin substrate, in which the non-conductive metal compound has a three-dimensional structure formed by vertex sharing of tetrahedrons including the Group 11 metal element; the adhesion-activated surface having metal cores including the Group 11 metal or the ion thereof which is exposed on the surface of the predetermined region of the polymer resin substrate; and the conductive metal layer formed on the adhesion-activated surface.

In the resin structure, the predetermined region where the adhesion-activated surface and the conductive metal layer are formed may correspond to the region of the polymer resin substrate to which the electromagnetic wave is irradiated. In addition, the Group 11 metal or the ion thereof included in the metal cores of the adhesion-activated surface may be derived from the non-conductive metal compound. Meanwhile, the conductive metal layer may be derived from the Group 11 metal or from the conductive metal ion included in the electroless plating solution.

Meanwhile, the resin structure may further include residues which are derived from the non-conductive metal compound dispersed in the polymer resin substrate. These residues may have a structure in which the Group 11 metal is at least partially released from the three-dimensional structure of the non-conductive metal compound, and therefore, vacancy is formed in at least one portion of the compound.

When the resin structure includes no color additive, L* value in the CIE L*a*b* color space may be approximately 80 to approximately 90. When the resin structure further includes the color additive, L* value may be approximately 90 to approximately 95, and preferably, approximately 92 to approximately 95. L* value in the CIE L*a*b* color space is a value that represents lightness. L*=0 represents black, and L*=100 represents white. Particularly, the non-conductive metal compound has a structure, in which outermost orbitals of the Group 11 metal element and the non-metal element are filled with electrons, respectively. Therefore, electron and orbital transitions may be minimized, and the non-conductive compound shows a light color. When the resin structure has the high brightness, it is easy to implement color such as a white color, etc.

Further, the resin structure may have MFR(300°C, 1.2kg) of approximately 25 g/10 min or less, and preferably, approximately 17 g/10 min to approximately 23 g/10 min. The MFR (melt index) is a flow rate when a melt is extruded at a high temperature of 300°C with a predetermined pressure, and is an index indicating thermal stability. A low MFR value represents superior thermal stability of a non-conductive metal compound in a polycarbonate resin. As confirmed in the following Experimental Example, the resin structure of one embodiment includes the non-conductive metal compound of the particular structure which has thermal and mechanical stability and has a MFR value of approximately 25 g/10 min or less, thereby showing excellent heat resistance.

Since the above-described resin structure is used to easily achieve a variety of colors including a white color and has superior thermal and mechanical stability, it may be applied to a variety of resin products or resin layers such as a mobile phone case having conductive patterns for antenna, or a variety of resin products or resin layers having conductive patterns such as RFID tags, various sensors, MEMS structures or the like.

As described above, according to embodiments of the present invention, it is possible to manufacture a variety of resin products having different fine conductive patterns by a very simplified process of laser electromagnetic irradiation and reduction or plating treatment.

Hereinafter, actions and effects of the present invention will be described in more detail with reference to specific Examples of the present invention. However, these Examples are only for illustrative purposes and are not intended to limit the scope of the present invention.

### Preparation Example 1: Synthesis of Non-Conductive Metal Compound CuI

A copper(II) salt, CuS and NaI or KI were stirred in an aqueous system to synthesize CuI powder by the following Reaction Scheme:

Cu²⁺ + 2I⁻ → CuI₂

2CuI₂ → 2CuI + I₂

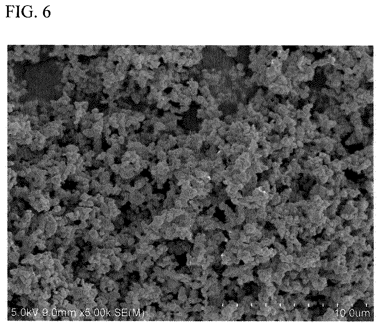

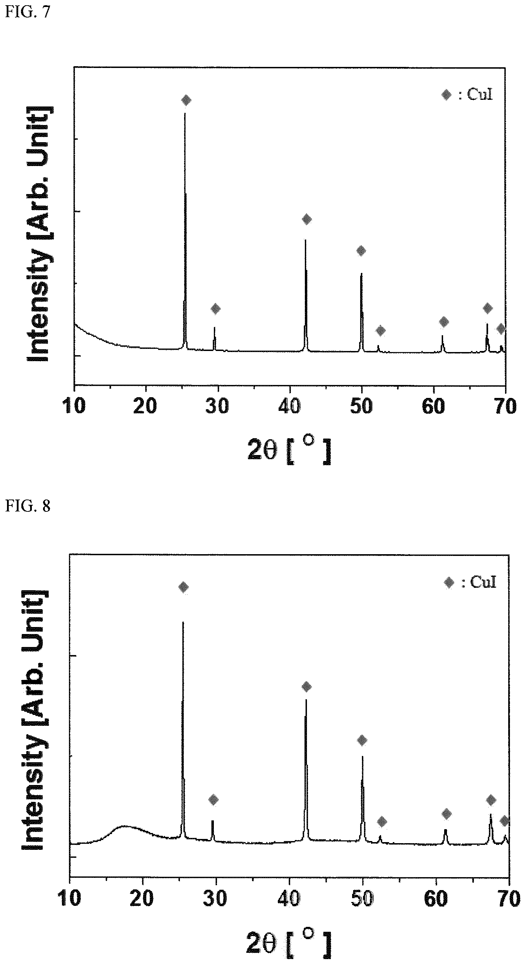

The CuI powder thus synthesized was additionally pulverized to have a particle size distribution of 100 nm ∼ 1 µm, and therefore, CuI powder to be used in the following Examples was prepared. Electron microscopic image and X-ray diffraction pattern of the powder are shown in FIGS. 6 and 7, respectively.

The electron microscopy and X-ray diffraction analysis showed that the non-conductive metal compound has a crystal structure, in which tetrahedrons were connected by vertex sharing, and the non-conductive metal compound was confirmed to have a three-dimensional structure as illustrated in FIG. 1.

### Example 1: Formation of Conductive Pattern by Direct Laser Irradiation

The non-conductive metal compound powder (CuI) obtained in Preparation Example 1 was used together with a polycarbonate resin. Additionally, a heat stabilizer (IR1076, PEP36), a UV stabilizer (UV329), a lubricant (EP184), and an impact modifier (S2001) which are additives for processing and stabilization were also used to prepare a composition for forming a conductive pattern by electromagnetic irradiation.

The polycarbonate resin of 88% by weight, the non-conductive metal compound of 7% by weight, the impact modifier of 4% by weight, and other additives including the lubricant of 1% by weight were mixed, and the mixture was extruded at 260°C to 280°C for blending so as to give a pellet-type resin composition. The pellet-type resin composition thus extruded was subjected to injection molding at approximately 260°C to approximately 280°C to give a substrate having a diameter of 100 mm and a thickness of 2 mm.

The substrate thus obtained was subjected to X-ray diffraction (XRD) analysis and the results are shown in FIG. 8. Referring to FIG. 8, it was confirmed that the non-conductive metal compound was favorably dispersed in the polycarbonate resin without degradation.

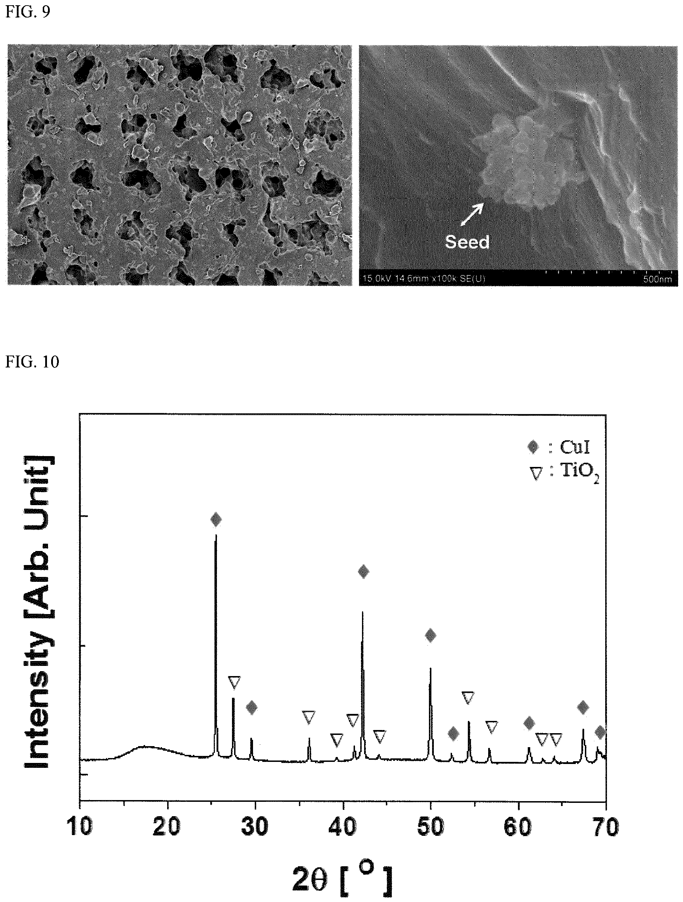

Meanwhile, the resin substrate manufactured as above was irradiated with laser having a wavelength of 1064 nm under the conditions of 40 kHz and 10 W using Nd-YAG laser to activate the surface. After laser irradiation, the shape of the polycarbonate surface and formation of the copper-containing metal cores in the resin were confirmed by electron microscopy, and the results are shown in FIG. 9 (left) (right), respectively. Referring to FIG. 9, a part of Cu or ion thereof derived from the CuI particles was reduced after laser irradiation, leading to formation of metal seeds (namely, metal cores).

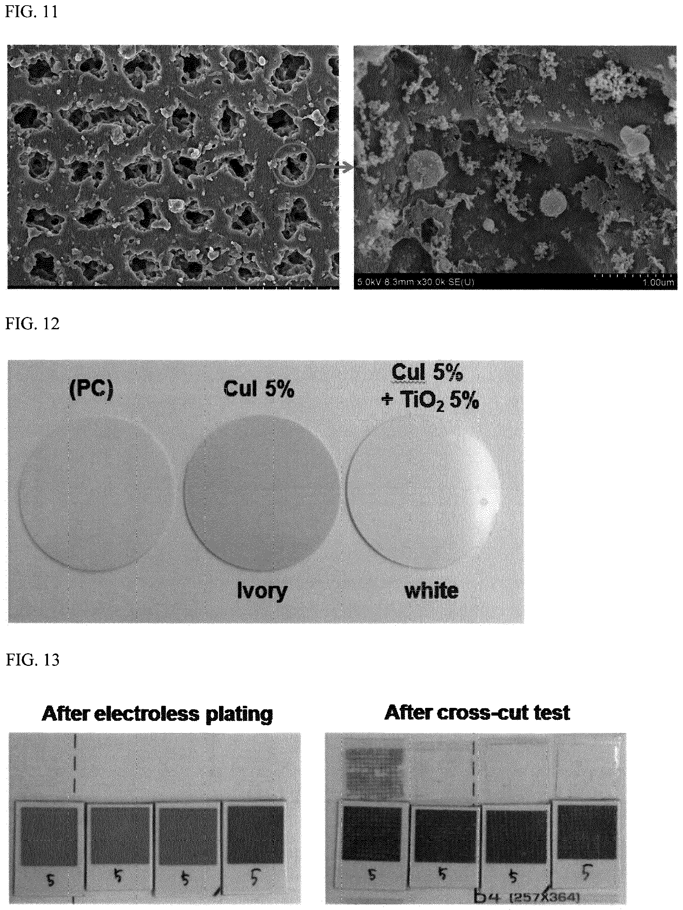

Subsequently, the resin substrate of which surface was activated by laser irradiation was subjected to an electroless plating process as follows. The plating solution was prepared by dissolving 3 g of copper sulfate, 14 g of Rochelle salt, and 4 g of sodium hydroxide in 100 ml of deionized water. 1.6 ml of formaldehyde as a reducing agent was added to 40 ml of the plating solution thus prepared. The resin substrate of which surface was activated by laser was immersed in the plating solution for 3 to 5 hours, and then washed with distilled water. Adhesion performance of the conductive pattern (or plating layer) thus formed was evaluated (FIG. 13) according to the standard ISO 2409. It was confirmed that a conductive pattern having excellent adhesion strength was formed on the polycarbonate resin substrate (see the following Experimental Example and Table 1).

### Example 2: Formation of Conductive Pattern by Direct Laser Irradiation

A composition for forming a conductive pattern was prepared in the same manner as in Example 1, except that the polycarbonate resin of 90% by weight and the non-conductive metal compound powder (CuI) of 5% by weight were used in Example 1, and a resin structure having the conductive pattern was manufactured therefrom. It was confirmed that a conductive pattern having excellent adhesion strength was formed on the polycarbonate resin substrate in the same manner as in Example 1 (see the following Experimental Example and Table 1).

### Example 3: Formation of Conductive Pattern by Direct Laser Irradiation

A composition for forming a conductive pattern was prepared in the same manner as in Example 1, except that the polycarbonate resin of 92% by weight and the non-conductive metal compound powder (CuI) of 3% by weight were used in Example 1, and a resin structure having the conductive pattern was manufactured therefrom. It was confirmed that a conductive pattern having excellent adhesion strength was formed on the polycarbonate resin substrate in the same manner as in Example 1 (see the following Experimental Example and Table 1).

### Example 4: Formation of Conductive Pattern by Direct Laser Irradiation

A composition for forming a conductive pattern, a substrate, and a resin structure having the conductive pattern were prepared in the same manner as in Example 1, except that the polycarbonate resin of 85% by weight, the non-conductive metal compound powder (CuI) of 5% by weight, and a color additive (TiO₂) of 5% by weight were used in Example 1.

The substrate manufactured by extrusion-molding the resin composition was subjected to X-ray diffraction (XRD) analysis and the results are shown in FIG. 10. Further, the result of an electron microscopic image to examine changes of the surface conditions of the resin substrate after laser irradiation of the substrate is illustrated in FIG. 11. For reference, FIG. 11 is an electron microscopic image of the fracture surface of the substrate, and the right image of FIG. 11 is a magnification of the left image. Referring to FIG. 10, it was confirmed that the non-conductive metal compound and the color additive (TiO₂) were favorably dispersed in the polycarbonate resin without degradation, before laser irradiation after extrusion, and these color additive and non-conductive metal compound particles were uniformly dispersed in the polycarbonate resin. Further, referring to FIG. 11, it was confirmed that even though the color additive was added to the non-conductive compound, the surface of the resin composition was readily activated by laser irradiation, and even after addition of the color additive, the color additive stably remained in the resin composition without degradation or reaction after laser irradiation.

Further, images of the polycarbonate resin substrate and the resin substrates manufactured in Example 2 and Example 4 are shown in FIG. 12. Referring to FIG. 12, the images clearly show that although the resin substrates manufactured in Example 2 and Example 4 included the non-conductive metal compound in addition to the polycarbonate resin, they exhibited a white color similar to that of the polycarbonate resin substrate.

Further, the resin structure having the conductive pattern of Example 4 showed excellent result in the adhesion strength test, and thus it was confirmed that the conductive pattern having excellent adhesion strength was formed on the polycarbonate resin substrate (see the following Experimental Example and Table 1).

### Comparative Example 1: Formation of Conductive Pattern by Direct Laser Irradiation

A composition for forming a conductive pattern was prepared in the same manner as in Example 4, except that Cu₂(OH)PO₄ was used as a non-conductive metal compound, instead of CuI, and a resin structure having the conductive pattern was manufactured therefrom.

### Comparative Example 2: Formation of Conductive Pattern by Direct Laser Irradiation

A composition for forming a conductive pattern was prepared in the same manner as in Example 4, except that Sb-SnO₂/mica was used as a non-conductive metal compound, instead of CuI, and a resin structure having the conductive pattern was manufactured therefrom.

### Experimental Example 1: Test of Adhesion Strength of Conductive Pattern

First, final conductive patterns were formed in Examples 1 to 4 and Comparative Examples 1 and 2, and then adhesion strength thereof was evaluated by a cross-cut test according to the standard ISO 2409, and the results are shown in the following Table 1.

According to Table 1, the conductive pattern showing excellent adhesion strength to the polycarbonate resin was formed in Examples 1 to 4.

**[Table 1]**

| | Example 1 | Example 2 | Example 3 | Example 4 | Comparative Example 1 | Comparative Example 2 |
|---|---|---|---|---|---|---|
| Polycarbonate resin [% by weight] | 88 | 90 | 92 | 85 | 85 | 85 |
| Non-conductive metal compound [% by weight] | 7 | 5 | 3 | 5 | 5 | 5 |
| Impact modifier [S2001, % by weight] | 4 | 4 | 4 | 4 | 4 | 4 |
| Color additive [% by weight] | 0 | 0 | 0 | 5 | 5 | 5 |
| Other additive [% by weight] | 1 | 1 | 1 | 1 | 1 | 1 |
| Laser irradiation power [W, at 1064 nm] | 9 | 9 | 9 | 9 | 9 | 9 |
| *Result of adhesion strength test (ISO Class) | 0 | 0 | 1 | 0 | 0 | 1 |

| | | | | | | |
|---|---|---|---|---|---|---|
| * in the adhesion strength test according to the standard ISO 2409, Class 0 indicates that a delamination area of a conductive pattern is 0% of an area of a conductive pattern to be evaluated and Class 1 indicates that a delamination area of a conductive pattern is more than 0% to 5% or less of an area of a conductive pattern to be evaluated. | | | | | | |

### Experimental Example 2: Test of White Color Implementation of Resin Structure

Physical properties of the resin structures manufactured in Examples 1 to 4 and Comparative Examples 1 to 2 were evaluated by the following method, and the results are shown in the following Table 2.

In the CIE L*a*b* color space, L* value represents lightness, L*=0 represents black, and L*=100 indicates white. a* represents a bias toward red or green. A negative a* value means tending to green, and a positive a* value means tending to red/violet, b* represents yellow and blue. A negative b* value means tending to blue, and a positive b* value means tending to yellow.

According to the following Table 2, when CuI powder was included in PC resins in Examples 1 to 3, excellent brightness was observed. As in Example 4, when TiO₂ was added to CuI powder, the concealing effect was excellent, and therefore, it is easy to achieve a white color. In particular, when Example 4 is compared with Comparative Examples 1 and 2, that is, when TiO₂ is used in the same amount, but other additive is included, use of CuI conclusively yields excellent brightness, indicating that use of CuI is advantageous in additional color implementation.

**[Table 2]**

| CIE color index | Example 1 | Example 2 | Example 3 | Example 4 | Comparative Example 1 | Comparative Example 2 |
|---|---|---|---|---|---|---|
| L* | 82 | 85 | 86 | 94 | 92 | 90 |
| a* | -0.56 | -0.72 | -0.70 | -1.08 | -2.48 | -1.96 |
| b* | 10.05 | 9.56 | 9.21 | 5.80 | 3.43 | 1.22 |

### Experimental Example 3: Test of Physical Properties of Resin Structure having conductive pattern

Test samples of the resin structures manufactured in Examples 1 to 4 and Comparative Examples 1 to 2 were prepared according to the ASTM Standard, and physical properties thereof were evaluated by the following method. The results are shown in the following Tables 3 and 4.

According to the following Tables 3 and 4, each of the resin structures having the conductive patterns manufactured by using CuI in Examples 1 to 4 showed excellent tensile strength, elongation, impact strength, etc., and also showed excellent thermal stability. In particular, when impact strength was compared between Comparative Examples 1 and 2 and Examples 1 to 4, addition of CuI improved impact strength. Specifically, there was a clear difference in 1/4" impact strength.

Further, as an exemplary thermal stability test of the resin structures manufactured in Examples 1 to 4 and Comparative Examples 1 to 2, a melt index (MFR) at 300°C was measured. The melt index (MFR) is a flow rate when a melt is extruded at a high temperature of 300°C with a predetermined pressure, and is an index indicating thermal stability. A high melt index indicates low thermal stability of a non-conductive metal compound in a polycarbonate resin.

Referring to the following Tables 3 and 4, the resin structures manufactured in Examples 1 to 4 had low MFR values to show excellent thermal stability, compared to those of Comparative Examples. More specifically, under the same conditions of the ingredient contents and the color additive, the resin structure of Example 4 manufactured by using CuI as the non-conductive metal compound showed a low MFR value, compared to the resin structure of Comparative Example 1 manufactured by using Cu₂(OH)PO₄ and the resin structure of Comparative Example 2 manufactured by using Sb-SnO₂/mica, which indicates that the composition for forming the conductive pattern including the non-conductive metal compound having the particular structure of one embodiment and the resin structure having the conductive pattern have excellent thermal stability.

**[Table 3]**

| Physical property | Measurement standard | Unit | Example 1 | Example 2 | Example 3 | Example 4 |
|---|---|---|---|---|---|---|
| Tensile strength | ASTM D638 | Kgf/cm² | 579 | 548 | 581 | 565 |
| Tensile elongation | ASTM D638 | % | 110 | 140 | 105 | 130 |
| Flexural Modulus | ASTM D790 | Kgf/cm² | 24,900 | 24,500 | 24600 | 25,300 |
| Flexural Strength | ASTM D790 | Kgf/cm² | 960 | 940 | 960 | 950 |
| Izod impact test (1/8", 23°C) | ASTM D256 | kgfcm/cm | 67 | 71 | 72 | 66 |
| Izod impact test (1/4", 23°C) | ASTM D256 | kgfcm/cm | 53 | 63 | 62 | 54 |
| (300°C, 1.2kg) MFR | ASTM D1238 | g/10 min | 22.3 | 21.5 | 20 | 18.3 |

| | | | | | | |
|---|---|---|---|---|---|---|
| *MFR (Mass Flow Rate, Melt index): a flow rate when a melt is extruded in a piston under predetermined conditions | | | | | | |

**[Table 4]**

| Physical property | Measurement standard | Unit | Comparative Example 1 | Comparative Example 2 |
|---|---|---|---|---|
| Tensile strength | ASTM D638 | Kgf/c m² | 570 | 601 |
| Tensile elongation | ASTM D638 | % | 120 | >100 |
| Flexural Modulus | ASTM D790 | Kgf/cm² | 25600 | 26100 |
| Flexural Strength | ASTM D790 | Kgf/cm² | 960 | 980 |
| Izod impact test (1/8", 23°C) | ASTM D256 | kgfcm/cm | 55 | 35 |
| Izod impact test (1/4", 23°C) | ASTM D256 | kgfcm/cm | 27 | 11 |
| MFR (300°C, 1.2kg) | ASTM D1238 | g/10min | 32 | 21.5 |

| | | | | |
|---|---|---|---|---|
| *MFR (Mass Flow Rate, Melt index): a flow rate when a melt is extruded in a piston under predetermined conditions | | | | |

## Claims

1. A composition for forming a conductive pattern, the composition comprising a polymer resin; and
a non-conductive metal compound comprising a coinage metal element [Group 11 (Group IB)] and a non-metal element, the non-conductive metal compound having a three-dimensional structure formed by vertex sharing of tetrahedrons comprising the Group 11 metal element, wherein the non-conductive metal compound is suitable to form a metal core comprising the Group 11 metal element or an ion thereof by electromagnetic irradiation,
wherein the non-conductive metal compound comprises a compound selected from the group consisting of CuI, CuCl, CuBr, CuF, and AgI,
the composition further comprising one or more additives selected from the group consisting of a heat stabilizer, a UV stabilizer, a flame retardant, a lubricant, an antioxidant, an inorganic filler, a color additive, an impact modifier, and a functional modifier,
wherein the color additive comprises one or more selected from the group consisting of carbon black, graphite, graphene, clay, talc, TiO₂, ZrO₂, Fe₂O₃, BaSO₄, CaCO₃, SiO₂, ZnS, ZnO, ZnCrO₄, Cr₂O₃, CoO·nAl₂O₃, Co₃(PO₄)₂, copper phthalocyanine, and quinacridone.

2. The composition for forming the conductive pattern of Claim 1, wherein the non-conductive metal compound has an average particle size of 1 µm or less, and is comprised in an amount of 1% by weight to 10% by weight, based on the total composition.

3. The composition for forming the conductive pattern of Claim 1, wherein the polymer resin comprises one or more selected from the group consisting of an acrylonitrile butadiene styrene (ABS) resin, a polyalkyleneterephthalate resin, a polycarbonate resin, a polypropylene resin, a polyphthalamide, nylon, and an elastomer resin.

4. A method of forming a conductive pattern, the method comprising:
molding the composition for forming the conductive pattern of any one of Claims 1 to 3 to a resin product or applying it to another product to form a resin layer;
irradiating an electromagnetic wave to a predetermined region of the resin product or the resin layer to generate a metal core comprising a Group 11 metal element or an ion thereof from a non-conductive metal compound; and
chemically reducing or plating the region generating the metal core in a plating solution containing metal ions to form a conductive metal layer.

5. The method of forming the conductive pattern of Claim 4, wherein in the generating of the metal core, a laser electromagnetic wave having a wavelength of 200 nm to 11,000 nm is irradiated at an average power of 1 W to 20 W.

6. The method of forming the conductive pattern of Claim 4, wherein when the generating of the metal core is carried out, the non-conductive metal compound is partially exposed on the surface of the predetermined region of the resin product or the resin layer, and the metal core is generated therefrom, thereby forming an adhesion-activated surface which is activated to have higher adhesion.

7. The method of forming the conductive pattern of Claim 4, wherein the conductive metal layer is formed on the adhesion-activated surface by chemical reduction of the Group 11 metal ion comprised in the metal core or by electroless plating thereof.

8. The method of forming the conductive pattern of Claim 4, wherein in the reducing or plating, the region generating the metal core is treated with an acidic or basic solution comprising a reducing agent comprising one or more selected from the group consisting of formaldehyde, hypophosphite, dimethylamino borane (DMAB), diethylamino borane (DEAB), and hydrazine.

9. A resin structure comprising:
a polymer resin substrate;
a non-conductive metal compound that comprises a Group 11 metal element and a non-metal element and is dispersed in a polymer resin substrate, the non-conductive metal compound having a three-dimensional structure formed by vertex sharing of tetrahedrons comprising the Group 11 metal element;
an adhesion-activated surface obtainable by generating a metal core comprising the Group 11 metal or the ion thereof by exposing the non-conductive metal compound on the surface of a predetermined region of the polymer resin substrate; and
a conductive metal layer formed on the adhesion-activated surface,
wherein the non-conductive metal compound comprises a compound selected from the group consisting of CuI, CuCl, CuBr, CuF, and AgI.

10. The resin structure of Claim 9, wherein the predetermined region where the adhesion-activated surface and the conductive metal layer are formed corresponds to a region of the polymer resin substrate to which an electromagnetic wave is irradiated.

11. The resin structure of Claim 9, wherein when the resin structure comprises no color additive, L* value in the CIE L*a*b* color space is 80 to 90, and when the resin structure further comprises a color additive, L* value is 90 to 95.

## Patentansprüche

1. Zusammensetzung zum Bilden eines leitfähigen Musters, die Zusammensetzung umfassend ein Polymerharz; und
eine nicht-leitfähige Metallverbindung, umfassend ein Münzmetallelement [Gruppe 11 (Gruppe IB)] und ein Nicht-Metallelement, wobei die nicht-leitfähige Metallverbindung eine dreidimensionale Struktur hat, gebildet durch das Teilen der Eckpunkte von Tetraedern umfassend das Gruppe 11-Metallelement, wobei die nicht-leitfähige Metallverbindung geeignet ist, einen Metallkern durch elektromagnetische Bestrahlung zu bilden, der das Gruppe 11-Metallelement oder ein Ion davon umfasst,
wobei die nicht-leitfähige Metallverbindung eine Verbindung umfasst, ausgewählt aus der Gruppe, bestehend aus CuI, CuCl, CuBr, CuF und AgI,
die Zusammensetzung ferner ein oder mehrere Additive umfasst, ausgewählt aus der Gruppe, bestehend aus einem Hitzestabilisator, einem UV-Stabilisator, einem Flammschutzmittel, einem Schmiermittel, einem Antioxidationsmittel, einem anorganischen Füllstoff, einem Farbadditiv, einem Schlagzahlmodifikationsmittel und einem funktionellen Modifikationsmittel,
wobei das Farbadditiv eines oder mehrere umfasst, ausgewählt aus der Gruppe, bestehend aus Ruß, Graphit, Graphen, Ton, Talkum, TiO₂, ZrO₂, Fe₂O₃, BaSO₄, CaCO₃, SiO₂, ZnS, ZnO, ZnCrO₄, Cr₂O₃, CoO·nAl₂O₃, Co₃(PO₄)₂, Kupferphthalocyanin und Chinacridon.

2. Zusammensetzung zum Bilden des leitfähigen Musters nach Anspruch 1, wobei die nicht-leitfähige Metallverbindung eine durchschnittliche Partikelgröße von 1 µm oder weniger hat und in einer Menge von 1 Gew.-% bis 10 Gew.-%, bezogen auf die gesamte Zusammensetzung, umfasst ist.

3. Zusammensetzung zum Bilden des leitfähigen Musters nach Anspruch 1, wobei das Polymerharz eines oder mehrere umfasst, ausgewählt aus der Gruppe, bestehend aus einem Acrylnitril-Butadien-Styrol(ABS)-Harz, einem Polyalkylenterephthalatharz, einem Polycarbonatharz, einem Polypropylenharz, einem Polyphthalamid, Nylon und einem Elastomerharz.

4. Verfahren zum Bilden eines leitfähigen Musters, das Verfahren umfassend:
Formen der Zusammensetzung zum Bilden des leitfähigen Musters nach einem der Ansprüche 1 bis 3 zu einem Harzprodukt oder Anwenden davon auf ein anderes Produkt, um eine Harzschicht zu bilden;
Einstrahlen einer elektromagnetischen Welle in einen vorbestimmten Bereich des Harzproduktes oder der Harzschicht, um einen Metallkern aus einer nicht-leitfähigen Metallverbindung zu bilden, der ein Gruppe 11-Metallelement oder ein Ion davon umfasst; und
chemisches Reduzieren oder Galvanisieren des Bereichs, der den Metallkern erzeugt, in einer Galvanisierungslösung, die Metallionen enthält, um eine leitfähige Metallschicht zu bilden.

5. Verfahren zum Bilden des leitfähigen Musters nach Anspruch 4, wobei für die Bildung des Metallkerns eine laserelektromagnetische Welle mit einer Wellenlänge von 200 nm bis 11.000 nm mit einer durchschnittlichen Leistung von 1 W bis 20 W eingestrahlt wird.

6. Verfahren zum Bilden des leitfähigen Musters nach Anspruch 4, wobei während des Erzeugens des Metallkerns die nicht-leitfähige Metallverbindung partiell auf der Oberfläche des vorbestimmten Bereichs des Harzproduktes oder der Harzschicht exponiert wird und der Metallkern hiervon gebildet wird, wodurch eine adhäsionsaktivierte Oberfläche gebildet wird, die hinsichtlich einer höheren Adhäsion aktiviert ist.

7. Verfahren zum Bilden des leitfähigen Musters nach Anspruch 4, wobei die leitfähige Metallschicht auf der adhäsionsaktivierten Oberfläche durch chemische Reduktion des Gruppe 11-Metallions, das in dem Metallkern umfasst ist, oder durch stromlose Abscheidung davon gebildet wird.

8. Verfahren zum Bilden des leitfähigen Musters nach Anspruch 4, wobei während des Reduzierens oder des Galvanisierens der Bereich, der den Metallkern bildet, mit einer sauren oder basischen Lösung behandelt wird, umfassend ein Reduktionsmittel, umfassend eines oder mehrere ausgewählt aus der Gruppe, bestehend aus Formaldehyd, Hypophosphit, Dimethylaminoboran (DMAB), Diethylaminoboran (DEAB) und Hydrazin.

9. Harzstruktur, umfassend:
einen Polymerharzträger;
eine nicht-leitfähige Metallverbindung, die ein Gruppe 11-Metallelement und ein Nicht-Metallelement umfasst, und in einem Polymerharzträger dispergiert ist, wobei die nicht-leitfähige Metallverbindung eine dreidimensionale Struktur hat, gebildet durch Teilen der Ecken von Tetraedern umfassend das Gruppe 11-Metallelement;
eine adhäsionsaktivierte Oberfläche, erhältlich durch Erzeugen eines Metallkerns umfassend das Gruppe 11-Metall oder das Ion davon durch Exponieren der nicht-leitfähigen Metallverbindung auf der Oberfläche eines vorbestimmten Bereichs des Polymerharzträgers; und
eine leitfähige Metallschicht, gebildet auf der adhäsionsaktivierten Oberfläche,
wobei die nicht-leitfähige Metallverbindung eine Verbindung umfasst, ausgewählt aus der Gruppe, bestehend aus CuI, CuCl, CuBr, CuF und AgI.

10. Harzstruktur nach Anspruch 9, wobei der vorbestimmte Bereich, in dem die adhäsionsaktivierte Oberfläche und die leitfähige Metallschicht gebildet werden, einem Bereich des Polymerharzträgers entspricht, der mit einer elektromagnetischen Welle bestrahlt wird.

11. Harzstruktur nach Anspruch 9, wobei in dem Fall, dass die Harzstruktur kein Farbadditiv umfasst der L*-Wert in dem CIE L*a*b* Farbraum 80 bis 90 ist und wenn die Harzstruktur ferner ein Farbadditiv umfasst, der L*-Wert 90 bis 95 ist.

## Revendications

1. Composition destinée à former un motif conducteur, la composition comprenant :
une résine polymère ; et
un composé de métal non-conducteur comprenant un élément métallique nouveau [Groupe 11 (Groupe IB)] et un élément non métallique, le composé de métal non-conducteur ayant une structure tridimensionnelle formée en partageant un sommet de tétrahédrons comprenant l'élément métallique du Groupe 11, dans laquelle le composé de métal non-conducteur convient pour former un noyau métallique comprenant l'élément métallique du Groupe 11 ou un ion de celui-ci par irradiation électromagnétique,
dans laquelle le composé de métal non-conducteur comprend un composé sélectionné dans le groupe constitué de CuI, CuCl, CuBr, CuF et AgI,
la composition comprenant en outre un ou plusieurs additifs sélectionnés dans le groupe constitué d'un stabilisant thermique, un stabilisant d'UV, un retardateur de flamme, un lubrifiant, un antioxydant, une charge inorganique, un additif de coloration, un agent antichoc et un agent modifiant fonctionnel,
dans laquelle l'additif de coloration comprend un ou plusieurs additifs sélectionnés dans le groupe constitué de noir de carbone, graphite, graphène, argile, talc, TiO₂, ZrO₂, Fe₂O₃, BaSO₄, CaCO₃, SiO₂, ZnS, ZnO, ZnCrO₄, Cr₂O₃, CoO•nAl₂O₃, Co₃(PO₄)₂, phtalocyanine de cuivre et quinacridone.

2. Composition destinée à former le motif conducteur selon la revendication 1, dans laquelle le composé de métal non-conducteur a une taille de particule moyenne égale ou inférieure à 1 µm, et est composé d'une quantité comprise entre 1 % en poids et 10 % en poids, sur la base de la composition totale.

3. Composition destinée à former le motif conducteur selon la revendication 1, dans laquelle la résine polymère comprend une ou plusieurs résines sélectionnées dans le groupe constitué d'une résine acrylonitrile butadiène styrène (ABS), une résine polyalkylène téréphtalate, une résine polycarbonate, une résine polypropylène, un polyphtalamide, un nylon et une résine élastomère.

4. Procédé de formation d'un motif conducteur, le procédé consistant à :
mouler la composition destinée à former le motif conducteur selon l'une quelconque des revendications 1 à 3 en un produit de résine ou l'appliquer à un autre produit pour former une couche de résine ;
irradier une onde électromagnétique vers une région prédéterminée du produit de résine ou de la couche de résine pour générer un noyau métallique comprenant un élément métallique du Groupe 11 ou un ion de celui-ci à partir d'un composé de métal non-conducteur ; et
réduire ou plaquer chimiquement la région générant le noyau métallique dans une solution de placage contenant des ions métalliques pour former une couche de métal conducteur.

5. Procédé de formation du motif conducteur selon la revendication 4, dans lequel dans la génération du noyau métallique, une onde électromagnétique laser ayant une longueur d'onde comprise entre 200 nm et 11 000 nm est irradiée à une puissance moyenne comprise entre 1 W et 20 W.

6. Procédé de formation du motif conducteur selon la revendication 4, dans lequel quand la génération du noyau métallique est effectuée, le composé de métal non-conducteur est exposé partiellement sur la surface de la région prédéterminée du produit de résine ou de la couche de résine, et le noyau métallique est généré à partir de là, formant ainsi une surface activée par adhérence qui est activée pour avoir une adhérence plus élevée.

7. Procédé de formation du motif conducteur selon la revendication 4, dans lequel la couche de métal conducteur est formée sur la surface activée par adhérence par réduction chimique de l'ion métallique du Groupe 11 compris dans le noyau métallique ou par dépôt autocatalytique de celui-ci.

8. Procédé de formation du motif conducteur selon la revendication 4, dans lequel dans la réduction ou le placage, la région générant le noyau métallique est traitée avec une solution acide ou basique comprenant un agent de réduction comprenant un ou plusieurs éléments sélectionnés dans le groupe constitué de formaldéhyde, hypophosphite, diméthylamino borane (DMAB), diéthylamino borane (DEAB) et hydrazine.

9. Structure de résine comprenant :
un substrat de résine polymère ;
un composé de métal non-conducteur qui comprend un élément métallique du Groupe 11 et un élément non métallique et qui est dispersé dans un substrat de résine polymère, le composé de métal non-conducteur ayant une structure tridimensionnelle formée en partageant un sommet de tétrahédrons comprenant l'élément métallique du Groupe 11 ;
une surface activée par adhérence pouvant être obtenue en générant un noyau métallique comprenant le métal du Groupe 11 ou l'ion de celui-ci en exposant le composé de métal non-conducteur sur la surface d'une région prédéterminée du substrat de résine polymère ; et
une couche de métal conducteur formée sur la surface activée par adhérence,
dans laquelle le composé de métal non-conducteur comprend un composé sélectionné dans le groupe constitué de CuI, CuCl, CuBr, CuF et AgI.

10. Structure de résine selon la revendication 9, dans laquelle la région prédéterminée où la surface activée par adhérence et la couche de métal conducteur sont formées, correspond à une région du substrat de résine polymère sur laquelle une onde électromagnétique est irradiée.

11. Structure de résine selon la revendication 9, dans laquelle quand la structure de résine ne comprend pas d'additif de coloration, une valeur L* dans l'espace de couleur CIE L*a*b* est comprise entre 80 et 90, et quand la structure de résine comprend en outre un additif de coloration, la valeur L* est comprise entre 90 et 95.
